# NEUE EUROPÄISCHE PATENTSCHRIFT

(11) **EP 1 623 609 B2**
(45) Veröffentlichungstag und Bekanntmachung des Hinweises auf die Entscheidung über den Einspruch: **26.09.2012**
(45) Hinweis auf die Patenterteilung: 22.04.2009
(21) Anmeldenummer: 04700977.4
(22) Anmeldetag: 09.01.2004
(51) Int. Cl.: H05K 7/14, H05K 5/04

(54) **ELEKTRISCHE VERSORGUNGSEINHEIT**
ELECTRICAL SUPPLY UNIT
UNITE D'ALIMENTATION ELECTRIQUE

(30) Priorität: 10.01.2003 DE 10300877
(43) Veröffentlichungstag der Anmeldung: 08.02.2006
(73) Patentinhaber: DORMA GmbH + Co. KG, 58256 Ennepetal (DE)
(72) Erfinder: RÖMER, Martin, 58339 Breckerfeld (DE); DRUX, Matthias, 58285 Gevelsberg (DE); HUFEN, Michael, 42289 Wuppertal (DE); HÄNSCH, Holger, 58452 Witten (DE)
(86) Internationale Anmeldenummer: PCT/EP2004/000089
(87) Internationale Veröffentlichungsnummer: WO 2004/064471

(56) Entgegenhaltungen:
- EP-A- 0 650 316
- EP-A1- 0 752 809
- EP-A2- 0 805 253
- WO-A-99/66771
- DE-A1- 3 712 294
- DE-A1- 4 342 740
- DE-C1- 19 609 855
- DE-U- 8 904 073
- DE-U- 9 319 849
- FR-A1- 2 278 148

## Beschreibung

Die Erfindung betrifft eine elektrische Versorgungseinheit für einen Türflügelantrieb nach dem Oberbegriff des Patentanspruches 1.

Türflügelantriebe sind hinlänglich bekannt und werden z. B. für den Antrieb von Drehtüren verwendet. Sie weisen eine Montageplatte auf, auf der die einzelnen Komponenten des Türflügelantriebes, z. B. ein Antrieb, eine Pumpe, ein Türschließer, ein Netzteil und weitere elektrische Komponenten, angeordnet sind. Wenn elektrische Bauteile defekt oder beschädigt sind, ist ein Austausch in der Regel erst möglich, wenn ein Großteil des Türflügelantriebes auseinander gebaut ist. Dies ist zeitaufwendig und kostenintensiv. Darüber hinaus sind die elektrischen Komponenten dezentral und entsprechend platzaufwendig angeordnet.

Aus der DE 93 19 849 U1 ist eine dem Oberbegriff des Anspruches 1 entsprechende elektrische Versorgungseinheit bekannt. Deren Gehäuse besteht aus einem U-förmigen Teil aus Leichtmetall, einer Abdeckhaube und einer seitlichen Abdeckung. Das Gehäuse besteht somit aus drei Teilen und erfordert infolgedessen einen erhöhten Aufwand beim Zusammenbauen und in der Lagerhaltung.

Ein weiteres Gehäuse für eine elektrische Versorgungseinheit ist aus der DE 89 04 073 U1 bekannt. Dieses Gehäuse besteht aus zwei U-förmigen Teilen, die ineinander gesteckt werden und dann ein geschlossenes Gehäuse bilden. Dieses Gehäuse bietet jedoch keine Haltemöglichkeit für Leiterplatten.

Die Aufgabe der vorliegenden Erfindung besteht deshalb darin, die vorstehend genannten Nachteile zu beseitigen und eine zentrale elektrische Versorgungseinheit für einen Türflügelantrieb zu schaffen, die einfach aufgebaut und wartungsfreundlich ist und trotzdem nur geringe Abmessungen aufweist.

Gelöst wird diese Aufgabe durch die im Patentanspruch 1 angegebenen Merkmale. Vorteilhafte Ausgestaltungen der elektrischen Versorgungseinheit ergeben sich aus den Unteransprüchen.

Erfindungsgemäß ist die elektrische Versorgungseinheit von einem metallischen Gehäuse umgeben, das aus zwei U-förmig gebogenen Blechzuschnitten zusammengesetzt ist, die gleichzeitig eine elektromagnetische Abschirmung für die in dem Gehäuse befindlichen Bauteile darstellen. Die Zweiteiligkeit des Gehäuses stellt eine wesentliche Vereinfachung des Gehäuseaufbaues dar und erleichtert den zentralen Einbau der elektrischen Bauteile. Darüber hinaus ist durch diese Anordnung auch nach erfolgter Montage, jederzeit durch Abnahme des einen Blechzuschnittes, der Zugriff auf die darin befindlichen Bauteile möglich. Außerdem müssen keine gesonderten Maßnahmen zur elektromagnetischen Abschirmung vorgenommen werden. Des Weiteren werden die Blechzuschnitte bereichsweise als Kühlfläche für sich erwärmende Bauteile benutzt, die dann flächig an den Blechzuschnitten anliegen. Auf separate Kühlkörper kann folglich verzichtet werden.

Weiterhin sind an einem die Montagebasis bildenden Blechzuschnitt Auflagen in zwei Ebenen ausgebildet, die den Einschub von gedruckten Leiterplatten ermöglichen. Die Auflagen sind aus dem Blechzuschnitt herausgebogen. Die Ausbildung derartiger.Auflagen ermöglicht jederzeit das Entfernen einer beispielsweise defekten Leiterplatte.

Die kraftschlüssige Verbindung beider Blechzuschnitte erfolgt an bestimmten Punkten durch Schraubverbindungen, wobei zusätzliche Stützelemente in Form von abgebogenen Laschen die Positionierung beider Blechzuschnitte zueinander stabilisieren.

Auf einer der beiden Leiterplatten ist ein Sicherungshalter befestigt, dessen Oberteil durch eine entsprechende Ausnehmung in einem Schenkel des ersten Blechzuschnittes ausgeschwenkt werden kann. Hierdurch kann eine defekte Sicherung ohne Öffnung des Gehäuses ausgetauscht werden.

Hinsichtlich der Packungsdichte der auf den Leiterplatten angeordneten Bauteile ist es weiterhin von Vorteil, das üblicherweise durch einen groß bauenden Transformator ausgebildete Netzteil eines Antriebes durch einen so genannten elektronischen Transformator zu ersetzen. Der elektronische Transformator zeichnet sich dadurch aus, dass er ausschließlich durch klein bauende elektronische Bauteile realisiert wird und somit auf die bisher üblichen groß bauenden Erregerspulen verzichtet. Insbesondere durch den Einsatz des elektronischen Transformators und die optimale Ausnutzung des zur Verfügung stehenden Bauraumes kann die elektrische Versorgungseinheit insgesamt wesentlich kleiner ausgestaltet werden.

Weitere Einzelheiten, Merkmale und Vorteile der Erfindung ergeben sich aus nachfolgender Beschreibung eines bevorzugten Ausführungsbeispieles anhand der Zeichnungen.

Es zeigen:
- Figur 1:: Eine perspektivische Ansicht einer elektrischen Versorgungseinheit.

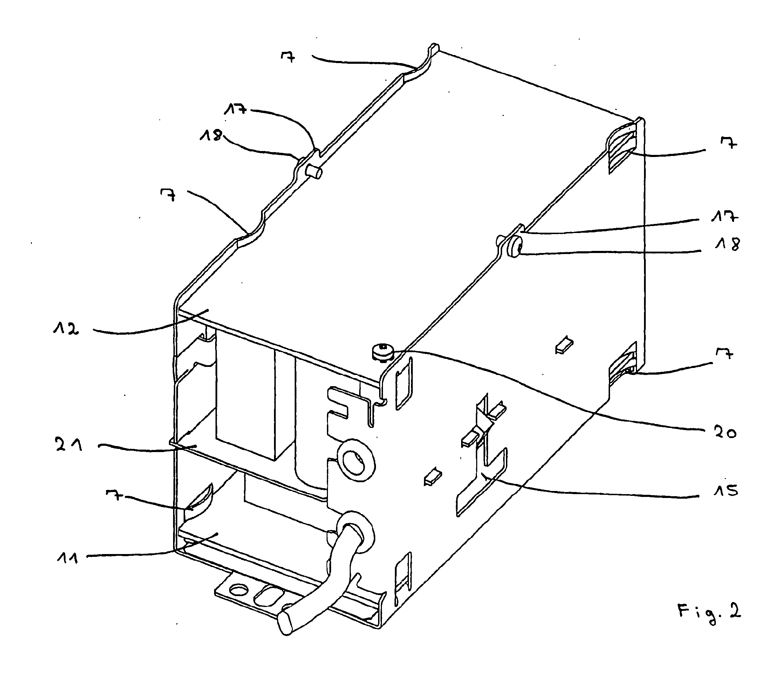

- Figur 2:: Eine perspektivische Ansicht einer geöffneten elektrischen Versorgungseinheit.

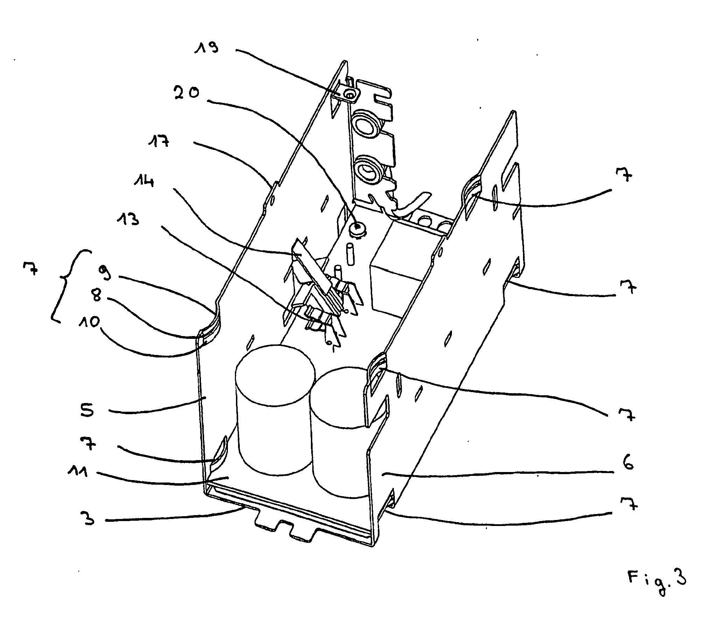

- Figur 3:: Eine perspektivische Ansicht einer teilweise bestückten elektrischen Versorgungseinheit.

Gleiche oder gleichwirkende Bauteile sind in der nachfolgenden Beschreibung mit gleichen Bezugszeichen versehen.

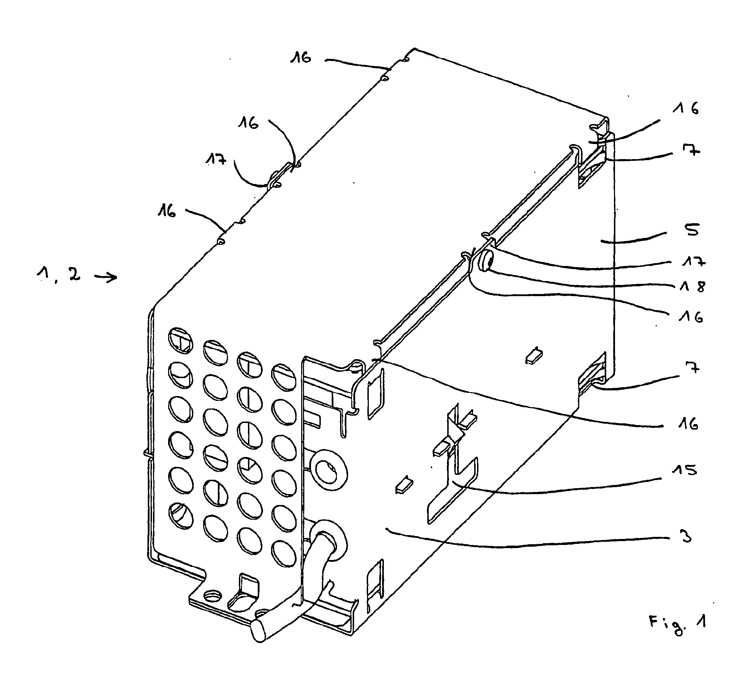

In der Figur 1 ist eine elektrische Versorgungseinheit 1 für einen Türflügelantrieb dargestellt. Die elektrische Versorgungseinheit 1 wird von einem zweiteiligen Gehäuse 2 umgeben, das aus zwei U-förmig gebogenen Blechzuschnitten 3 und 4 zusammengesetzt ist. Im zusammengesetzten Zustand beider Blechzuschnitte 3, 4 ergibt sich eine kubische Form des Gehäuses 2. Das derart zusammengesetzte Gehäuse 2 stellt aufgrund der metallischen Materialausbildung gleichzeitig eine elektromagnetische Abschirmung und einen Kühlkörper für die in dem Gehäuse 2 befindlichen elektrischen Bauteile dar.

Der Blechzuschnitt 3 bildet eine Montagebasis, da in diesem Blechzuschnitt 3 alle wesentlichen Bauteile des Gehäuses 2 kraftschlüssig befestigt sind. Hierzu sind in dem Blechzuschnitt 3 an den beiden Schenkeln 5 und 6 mehrere Auflagen 7 ausgebildet, die sich über zwei Ebenen verteilen. Die Auflagen 7 sind dadurch realisiert, dass in den Schenkeln 5 und 6 jeweils unter Ausbildung eines Einschubspaltes 8 Blechstreifen 9 und 10 gehäuseeinwärts gebogen sind. In diese Auflagen 7 sind zwei gedruckte Leiterplatten 11 und 12 eingeschoben, die an einer laschenförmig abgebogenen Auflage 19 rutschfest mittels einer Schraube 20 positioniert sind. Die Leiterplatten 11 und 12 sind, mit ihren bestückten Seiten gegensinnig zueinander positioniert und über ein nicht dargestelltes Flachkabel elektrisch miteinander verbunden. Zwischen den beiden Leiterplatten 11 und 12 ist eine separate Abschirmung 21 angeordnet.

Vorzugsweise ist auf der in den Figuren unten angeordneten Leiterplatte 11 ein Sicherungshalter 13 montiert. Der Sicherungshalter 13 weist ein Oberteil 14 auf, das durch eine entsprechende Ausnehmung 15 in dem Schenkel 5 des Blechzuschnittes 3 ausgeschwenkt werden kann, so dass jederzeit auf eine nicht dargestellte Sicherung zugegriffen werden kann.

Darüber hinaus befindet sich auf den Leiterplatten 11 und 12 ein so genannter, nicht näher dargestellter elektronischer Transformator, der ausschließlich durch elektronische Bauteile realisiert ist. Innerhalb des elektronischen Transformators 16 ist eine nicht näher bezeichnete Takteinrichtung angeordnet, welche eine netzfrequente Eingangsspannung des Antriebes in eine hochfrequente Niederspannung umwandelt, die zur Steuerung des Antriebes benutzt wird.

Beim Zusammenbau der beiden Blechzuschnitte 3 und 4 des Gehäuses 2 stützen sich an dem Blechzuschnitt 4 ausgebildete Laschen 16 auf der oben angeordneten Leiterplatte 12 ab. An den Schenkeln 5 und 6 des Blechzuschnittes 3 sind Ansätze 17 ausgebildet, durch die Schrauben 18 in einige der Laschen 16 geschraubt werden, um eine kraftschlüssige Verbindung beider Blechzuschnitte 3 und 4 zu gewährleisten. Die beschriebene Befestigungstechnik ermöglicht, dass das Gehäuse 2 jederzeit, sowohl zu Montage- als auch zu Wartungszwecken einfach geöffnet werden kann.

Die vorstehende Beschreibung des Ausführungsbeispieles dient nur zu illustrativen Zwecken und nicht zum Zwecke der Beschränkung der Erfindung. Im Rahmen der Erfindung sind verschiedene Änderungen und Modifikationen möglich, ohne den Umfang der Erfindung sowie ihrer Äquivalente zu verlassen.

### Bezugszeichenliste

- 1: elektrische Versorgungseinheit
- 2: Gehäuse
- 3: Blechzuschnitt
- 4: Blechzuschnitt
- 5: Schenkel
- 6: Schenkel
- 7: Auflage
- 8: Einschubspalt
- 9: Blechstreifen
- 10: Blechstreifen
- 11: Leiterplatte
- 12: Leiterplatte
- 13: Sicherungshalter
- 14: Oberteil
- 15: Ausnehmung
- 16: Lasche
- 17: Ansatz
- 18: Schraube
- 19: Auflage
- 20: Schraube
- 21: Abschirmung

## Patentansprüche

1. Elektrische Versorgungseinheit für einen Türflügelantrieb mit einem Gehäuse (2),
**dadurch gekennzeichnet, dass**
• das Gehäuse (2) aus einem ersten und einem zweiten U-förmig gebogenen Blechzuschnitt (3, 4) zusammensetzbar ist,
• die Blechzuschnitte (3, 4) die in dem Gehäuse (2) befindlichen Bauteile elektromagnetisch abschirmen,
• an dem ersten Blechzuschnitt (3) Auflagen (7) in zwei Ebenen angeordnet sind, in die zwei Leiterplatten (11, 12) einschiebbar sind,
• die Auflagen (7) durch gehäuseeinwärts gebogene Blechstreifen (9) und (10) gebildet sind,
• zwischen den Blechstreifen (9) und (10) ein Einschubspalt (8) verbleibt,
• sich beim Zusammenbau der Blechzuschnitte (3, 4) des Gehäuses (2) sich an dem zweiten Blechzuschnitt (4) ausgebildete Laschen (16) auf der Leiterplatte (12) abstützen, die einem Bodenteilabschnitt des zweiten Blechzuschnitts (4) näher angeordnet ist als die andere der zwei Leiterplatten (11,12), wobei der Bodenab schnitt Schenkel des zweiten Blechzuschnitts miteinander verbindet und die Leiterplatten parallel zum Bodenabschnitt angeordnet sind, und
• an Schenkeln (5, 6) des ersten Blechzuschnittes (3) Ansätze (17) ausgebildet sind, durch die Schrauben 18 in einige der Laschen (16) des zweiten Blechzuschnitts (4) geschraubt werden, um eine kraftschlüssige Verbindung beider Blechzuschnitte (3, 4) zu gewährleisten.

2. Elektrische Versorgungseinheit nach Anspruch 1, **dadurch gekennzeichnet, dass** auf einer gedruckten Leiterplatte (11) ein Sicherungshalter (13) angeordnet ist, dessen Oberteil (14) durch eine Ausnehmung (15) in einem Schenkel (5, 6) des ersten Blechzuschnittes (3) ausschwenkbar ist.

3. Elektrische Versorgungseinheit nach einem der vorhergehenden Patentansprüche, **dadurch gekennzeichnet, dass** auf einer der Leiterplatten (11, 12) ein elektronischer Transformator angeordnet ist.

## Claims

1. An electrical supply unit for a door leaf operator with a housing (2),
**characterized in that**
• a first and a second U-shape bent sheet-metal blank (3, 4) can be joined together to form the housing (2),
• the sheet-metal blanks (3, 4) electro-magnetically shield the components located in the housing (2),
• support edges (7), into which the two printed circuit boards (11, 12) are insertable, are disposed in two planes at the first sheet-metal blank (3),
• the support edges (7) are configured by sheet-metal strips (9) and (10), which are bent to the inside of the housing,
• a slide-in slot (8) remains between the sheet-metal strips (9) and (10),
• when assembling the sheet-metal blanks (3, 4) of the housing (2), link-plates, configured at the second sheet-metal blank (4), bear on the printed circuit board (12), which is disposed closer to a bottom section of the second sheet-metal blank (4) than the other one of the two printed circuit boards (11, 12), wherein the bottom section interconnects legs of the second sheet-metal blank, and the printed circuit boards (11, 12) are disposed parallel to the bottom section, and
• shoulders (17) are configured at the legs (5, 6) of the first sheet-metal blank (3), through which shoulders screws (18) are screwed into some of the link-plates (16) of the second sheet-metal blank (4) in order to guarantee a non-positive connection of the two sheet-metal blanks (3, 4).

2. The electrical supply unit according to claim 1, **characterized in that** a fuse carrier (13) is disposed on one printed circuit board (11), the top part (14) thereof being able to swivel out through an opening (15) in one leg (5, 6) of the first sheet-metal blank (3).

3. The electrical supply unit according to one of the preceding claims, **characterized in that** an electronic transformer is disposed on one of the printed circuit boards (11, 12).

## Revendications

1. Unité d'alimentation électrique pour un entraînement de vantail de porte comprenant un boîtier (2),
**caractérisée en ce que**
• le boîtier (2) peut être assemblé à partir d'une première et d'une deuxième pièce en tôle découpée (3, 4) coudée en forme de U,
• les pièces en tôle découpée (3, 4) font écran électromagnétique pour les composants se trouvant dans le boîtier (2),
• des appuis (7) sont agencés en deux plans sur la première pièce en tôle découpée (3), dans quels appuis deux cartes de circuits imprimés (11, 12) sont insérables,
• les appuis (7) sont aménagés par l'intermédiaire de bandes de tôle (9) et (10) coudées vers l'intérieur du boîtier,
• une baie d'introduction (8) est aménagée entre les bandes en tôle (9) et (10),
• pendant l'assemblage des pièces en tôle découpée (3, 4) du boîtier (2), des pattes aménagées sur la deuxième pièce en tôle découpée (4) s'appuient sur la carte de circuit imprimé (12), qui est agencée plus près d'une portion de fond de la deuxième pièce en tôle découpée (4), que l'autre des deux circuits imprimés (11, 12), la portion de fond reliant des branches de la deuxième pièce en tôle découpée et **en ce que** les cartes des circuits imprimés (11, 12) sont agencés parallèlement par rapport à la portion de fond, et
• des épaulements (17) sont aménagés sur les branches (5, 6) de la première pièce en tôle découpée (3), à travers desquels des écrous (18) sont vissés dans quelques unes des pattes (16) de la deuxième pièce en tôle découpée (4), afin de garantir une connexion par la force entre les deux pièces en tôle découpée (3, 4).

2. Unité d'alimentation électrique selon la revendication 1, **caractérisée en ce qu'**un porte-fusible (13) est agencé sur une carte de circuit imprimé (11) dont la pièce supérieure (14) est pivotable à travers une ouverture (15) dans une branche (5, 6) de la première pièce en tôle découpée (3).

3. Unité d'alimentation électrique selon l'une des revendications précédentes, **caractérisée en ce qu'**un transformateur électronique est agencé sur l'une des cartes de circuits imprimés (11, 12).
